# EUROPÄISCHE PATENTSCHRIFT

(11) **EP 2 188 855 B1**
(45) Veröffentlichungstag und Bekanntmachung des Hinweises auf die Patenterteilung: **07.03.2018**
(21) Anmeldenummer: 08803623.1
(22) Anmeldetag: 04.09.2008
(51) Int. Cl.: H01L 51/42

(54) **ORGANISCHER PHOTODETEKTOR ZUR DETEKTION INFRAROTER STRAHLUNG, VERFAHREN ZUR HERSTELLUNG DAZU UND VERWENDUNG**
ORGANIC PHOTODETECTOR FOR THE DETECTION OF INFRARED RADIATION, METHOD FOR THE PRODUCTION THEREOF, AND USE THEREOF
PHOTODÉTECTEUR ORGANIQUE CONÇU POUR DÉTECTER UN RAYONNEMENT INFRAROUGE, PROCÉDÉ DE FABRICATION ET UTILISATION DE CELUI-CI

(30) Priorität: 13.09.2007 DE 102007043648
(43) Veröffentlichungstag der Anmeldung: 26.05.2010
(73) Patentinhaber: Siemens Healthcare GmbH, 91052 Erlangen (DE)
(72) Erfinder: BÖBERL, Michaela, A-4470 Enns (AT); FÜRST, Jens, 91074 Herzogenaurach (DE); HEISS, Wolfgang, A-4020 Linz (AT); KOVALENKO, Maksym, Chicago IL 60637 (US); RAUCH, Tobias, 82256 Fürstenfeldbruck (DE)
(86) Internationale Anmeldenummer: PCT/EP2008/061653
(87) Internationale Veröffentlichungsnummer: WO 2009/037121

(56) Entgegenhaltungen:
- WO-A2-2006/130717
- US-A1- 2007 102 694
- MCDONALD S A ET AL: "Solution-processed PbS quantum dot infrared photodetectors and photovoltaics" NATURE MATERIALS FEBRUARY 2005 NATURE PUBLISHING GROUP GB, Bd. 4, Nr. 2, Februar 2005 (2005-02), Seiten 138-142, XP002507123
- XIAOMEI JIANG ET AL: "PbSe nanocrystal/conducting polymer solar cells with an infrared response to 2 micron" JOURNAL OF MATERIALS RESEARCH, MATERIALS RESEARCH SOCIETY, WARRENDALE, PA, Bd. 22, Nr. 8, 1. August 2007 (2007-08-01), Seiten 2204-2210, XP009109750 ISSN: 0884-2914
- SHIGA ET AL: "Photovoltaic performance and stability of CdTe/polymeric hybrid solar cells using a C60 buffer layer" SOLAR ENERGY MATERIALS AND SOLAR CELLS, ELSEVIER SCIENCE PUBLISHERS, AMSTERDAM, NL, Bd. 90, Nr. 12, 24. Juli 2006 (2006-07-24), Seiten 1849-1858, XP005408785 ISSN: 0927-0248
- T. RAUCH, M. BÖBERL, M. KOVALENKO, S. TEDDE, U. LEMMER, J. FÜRST, W. HEISS, O. HAYDEN: "Near Infrared Sensitivity of PbS Quantum Dot Sensitized Organic Photodiodes" DPG-VERHANDLUNGEN, ORGANIC POLYMER-METAL INTERFACES (SYSA 7), 25. Februar 2008 (2008-02-25), - 29. Februar 2008 (2008-02-29) XP002507180 72. Jahrestagung, Berlin Gefunden im Internet: URL:http://www.dpg-verhandlungen.de/2008/b erlin/ds20.pdf>

## Beschreibung

Die Erfindung betrifft einen organischen Photodetektor für infrarote Strahlung, insbesondere einen der im Spektralbereich über 1100nm Strahlung, dem so genannten Imagerbereich, detektiert. Außerdem betrifft die Erfindung ein Verfahren zur Herstellung eines derartigen Photodetektors sowie Verwendungen davon.

Aus der WO2007/017470 ist ein organischer Photodetektor bekannt, bei dem eine anorganisch basierte Transistormatrix durch eine Passivierungsschicht als Substrat für den einfachen und kostengünstig herstellbaren Aufbau eines organischen Photodetektors dient.

X. Jiang et al., J. Mater. Res., Bd. 22, Nr. 8, Aug. 2007 beschreibt die photoaktive Schicht einer Solarzelle, die aus einem lochtransportierendem Polythiophen und einem eletrontransportierendem halbleitendem Nanopatikel besteht. Die photoaktive Schicht von WO2006/130717 weist eine Bulk-Heterojunction aus einem lochtransportierendem Polythiophen und einem elektrontransportierendem Fulleren Derivat auf, die Schwermetall-Nanopartikel enthält.

Photodetektoren, die im Spektralbereich über 1100nm arbeiten, sind bislang nur auf anorganischer Basis bekannt. Es gibt so genannte Bolometer, die bei Erwärmung durch IR-Strahlung Widerstandsänderung erfahren. Außerdem gibt es Photodioden aus anorganischen "Narrow Band Gap" Halbleitern (II-VI, IV-VI). Schließlich gibt es Quantentopf- und Quantenpunkt IR-Photodetektoren, die aus Halbleitern mit unterschiedlichen Bandlücken epitaktisch gewachsen werden und die ebenfalls im längerwelligen IR-bereich Strahlung detektieren.

Nachteilig an all diesen Systemen ist jedoch, dass sie unter Verwendung von nicht unerheblichen Mengen an kostspieligen und toxikologisch bedenklichen Halbleitermaterialien, wie z.B. Indium Gallium Arsenid, Germanium und/oder Bleisulfid hergestellt werden. Zudem werden die bekannten Photodetektoren unter hohem technischem und kostenintensivem Aufwand hergestellt.

Aufgabe der vorliegenden Erfindung ist es deshalb, einen Photodetektor für den Imagerbereich zur Verfügung zu stellen, der unter Verminderung der Menge an toxikologisch bedenklichem Material gegenüber den bisher bekannten Photodetektoren durch eine vereinfachte und kostengünstigere Methode herstellbar ist.

Gegenstand der Erfindung und Lösung der Aufgabe ist ein Photodetektor auf organischer Basis nach Anspruch 1. Außerdem ist Gegenstand der Erfindung ein Verfahren zur Herstellung eines Photodetektors auf organischer Basis nach Anspruch 6. Schließlich ist Gegenstand der Erfindung die Verwendung dieses Photodetektors auf organischer Basis in der IR-Tomographie (IR-imaging) und in der Sicherheitstechnik.

Nach einer vorteilhaften Ausführungsform der Erfindung liegen die enthaltenen Nanopartikel zumindest teilweise in Form von Nanokristallen vor.

Nach einer vorteilhaften Ausführungsform der Erfindung sind die halbleitenden Nanopartikel oder Nanokristalle in der organisch basierten photoaktiven Schicht löslich, so dass die Vorteile bei der Herstellung organischer Elektronik, insbesondere die lösungsbasierte Prozessierung, trotz der eingesetzten Nanokristalle beibehalten werden kann. Damit kann gewährleistet werden, dass die organisch basierte photoaktive Schicht weiterhin durch bekannte Depositionsverfahren wie Spin-Coating, Rakeln, und/oder Druckverfahren auf die jeweiligen Substrate kostengünstig aufbringbar ist. Dadurch sind sowohl großflächige als auch pixelierte IR-Photodetektoren herstellbar.

Durch die lösungsprozessierbaren Aufbringungstechniken erschließen sich eine große Reihe von Substraten, auch in flexibler Form, wobei halbfertige aber auch fertige Bauelemente zur Aufbringung organischer Photodioden durch effiziente Methoden auch in gestapelter und/oder mehrlagiger Form geeignet sind.

Nach einer besonders vorteilhaften Ausführungsform sind die Nanopartikel oder Nanokristalle in der photoaktiven Schicht zumindest zum Teil kolloidal enthalten.

Durch die Auswahl und Größe der Nanopartikel kann der Wellenlängenbereich, in dem detektiert wird, beeinflusst werden.

Als organisch basierte Photodetektoren eignen sich beispielsweise Photodioden aus eine vertikalem Schichtsystem, wobei beispielsweise zwischen einer unteren Indium-Zinn -Oxid-Elektrode (ITO-Elektrode) und einer oberen, beispielsweise Calcium und Silber umfassenden Elektrode sich eine PEDOT-Schicht mit einem P3HT-PCBM-Blend befindet. Der Blend aus den beiden Komponenten P3HT (Poly(hexylthiophene)-2-5-diyl) als Absorber und/oder Lochtransportkomponente und PCBM Phenyl-C61- als Elektronenakzeptor und/oder Elektronenleiter wirkt als so genannte "bulk-heterojunction", das heißt die Trennung der Ladungsträger erfolgt an den Grenzflächen der beiden Materialien, die sich innerhalb des gesamten Schichtvolumens ausbilden. Die Lösung kann durch Ersetzen oder Zumischen weiterer Materialien modifiziert werden. Gemäß der Erfindung wird die Lösung durch Zumischung der Nanopartikel verändert, so dass eine erhebliche Erweiterung der spektralen Empfindlichkeit in den infraroten Spektralbereich resultiert.

Diese Erweiterung in den infraroten Spektralbereich wird durch den quantenmechanischen Effekt der Quantisierung von Energieniveaus der Nanopartikel und/oder durch die Quantenpunkte aus den II-VI, IV-VI-Halbleitern bewirkt. Ein großer, dreidimensionaler Halbleiterkristall besitzt eine Energielücke. Treffen Photonen mit einer Energie größer als diese Energielücke auf den Kristall, werden elektrischen Ladungen in Form von Elektron-Loch-Paaren erzeugt. Wird die Größe des Kristalls in allen 3 Dimensionen reduziert, wird die Energielücke des Kristalls zu höheren Energien verschoben. So kann beispielsweise die Energielücke von PbS von ca. 0.42eV (entsprechend einer Lichtwellenlänge von ca. 3µm) in Nanokristallen mit einer Größe von ca. 10nm auf 1eV (entsprechend einer Lichtwellenlänge von 1240nm) angehoben werden. Wird der Durchmesser der Nanopartikel verändert, so ändern sich auch deren Absorptions- oder Emissionsverhalten.

Wie soeben beschrieben kann man durch einen Bleisulfid (PbS)-Nanokristall eine Absorption erhalten, die um die 1150nm liegt. Eine weitere Modifizierung des Absorptionsbereiches ist aus den oben genannten Gründen durch einfache Auswahl der Geometrie oder des Materials der Nanopartikel möglich.

Beispielsweise kann durch Variation des Kristalldurchmessers der sensitive Wellenlängenbereich von ca. 850nm bis 1800nm eingestellt werden. Durch Wechsel des Materialsystems beispielsweise von Bleisulfid auf Bleiselenid (PbSe) sind Wellenlängen von bis zu 4 µm erreichbar.

Ganz generell können verschiedene Nanopartikel oder Mischungen verschiedener Nanopartikel eingesetzt werden. Beispielsweise sind die Nanopartikel aus Bleisulfid, Cadmiumtellurid (CdTe), Quecksilbertellurid (HgTe) und/oder Bleiselenid (PbSe).

Die Nanopartikel befinden sich üblicherweise in Lösungen mit einer Konzentration von 1-50mg/ml. In der aktiven Schicht ist der Gewichtsanteil der Nanopartikel in der gleichen Größenordnung wie der der anderen Stoffe. Beispielsweise ist das Gewichtsverhältnis in einem Detektor mit PbS:P3HT:PCBM aktiver Schicht z.B. 2:1:1. Die Beimischung kann durch Zugabe zu dem Bulk-Heterojunction-System bewerkstelligt werden, so dass eine Bulk-Heterojunction "PbS:P3HT:PCBM) resultiert.

Im IR-Bereich absorbieren die Nanopartikel, wodurch angeregte Ladungsträger entstehen, die mithilfe einer angelegten Spannung extrahiert werden. Darüber hinaus kann durch eine elektrische Spannung der Photoleitungseffekt ausgenutzt und somit das Signal ohne Vorstufe verstärkt werden.

Da organische Lösungen nahezu auf jedem Substrat prozessierbar sind, können optische Spezifikationen bei der Auswahl der Substrate im Wesentlichen berücksichtigt werden, so dass Folien oder Substrate, beschichtet oder unbeschichtet verwendet werden können, die nur im jeweiligen Spektralbereich durchlässig sind, wie z.B. GaAs > 870 nm; Si >1100nm oder Substrate mit Filterbeschichtungen.

Eine Verwendung der vorgeschlagenen organischen IR-Photodetektoren als Lichtschranken oder Detektorvorhänge in der Sicherheitstechnik ist möglich, weil durch den Einsatz der großflächig applizierbaren Photodetektoren ein großer Sicherheitsbereich geschaffen werden kann. Die Funktionsweise des Sicherheitselements ist dabei konventionell, beispielsweise so, dass wenn ein Arbeiter in den Sicherheitsbereich einer Maschine gelangt, unterbricht er den Lichtstrahl und löst dadurch geeignete Sicherheitsmaßnahmen, wie z.B. die Abschaltung der Anlage aus.

Im Folgenden wird die Erfindung noch anhand von Ausführungsbeispielen und Figuren, die die Ergebnisse von Messungen an den Ausführungsbeispielen zeigen, näher erläutert.
- Figur 1: zeigt den schematischen Aufbau eines organischen Photodetektors,
- Figur 2: zeigt die externen Quanteneffizienzen von mit Bleisulfid versetzten Bulk-Heterojunction-Materialsystemen,
- Figuren: 3a und 3b zeigen die externe Quanteneffizienz in Abhängigkeit von der angelegten Rückwärtsspannung und
- Figuren: 4a und 4b schließlich zeigen die Linearität über mehr als 2 Dekaden für Licht der Wellenlänge 550nm und 1150nm.

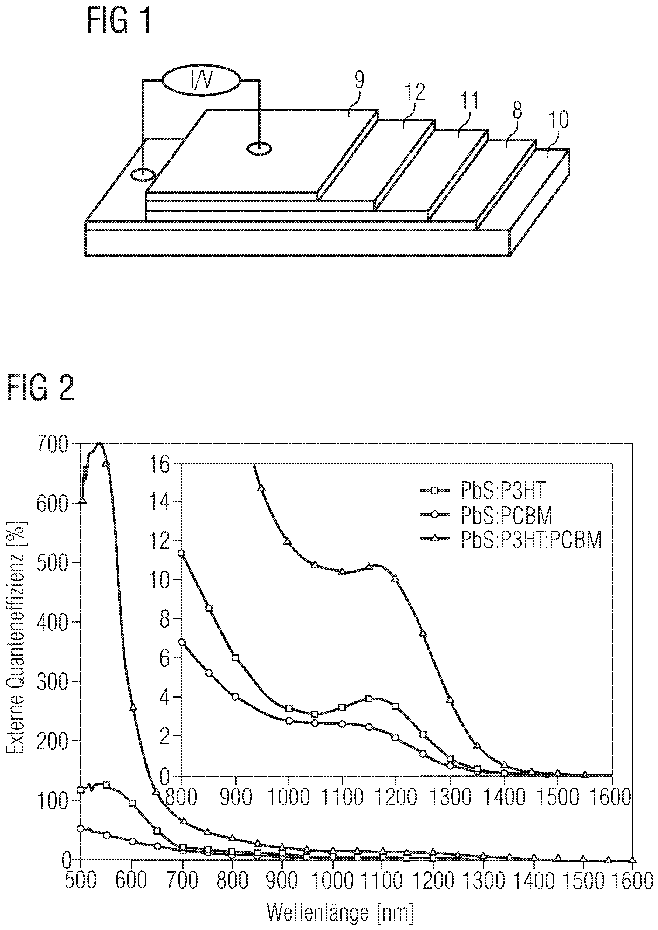

Figur 1 zeigt beispielhaft den Aufbau einer organischen Photodiode. Die Diode besteht aus einer oder mehreren aktiven organischen Schichten, die zwischen zwei Elektroden 8, 9 auf ein Substrat 10 aufgebracht werden. Das Substrat 10 besteht typischerweise aus Glas, es kann aber auch aus einer Metallfolie-, Kunststofffolie oder einem sonstigen Trägermaterial aufgebaut sein. Als mögliches flexibles Substrat kommt z.B. eine für sichtbares Licht undurchlässige Folie, wie sie im Leopard II Panzer verwendet werden, in Frage.

Im gezeigten Beispiel ist die untere Elektrode 8 als Anode und die obere Elektrode 9 als Kathode realisiert, die Polarität der Elektroden kann aber auch invers aufgebaut sein.

Figur 1 zeigt einen Schichtaufbau mit zwei aktiven organischen Schichten: einem Lochtransporter 11 und der eigentlichen photoleitfähigen Schicht 12. Zusätzlich zu den hier gezeigten Schichten ist noch der Schutz des Bauteils mittels einer Verkapselung nötig. Die photoleitfähige organische Schicht 12 ist die so genannte "Bulk Heterojunction", zum Beispiel realisiert als Blend aus einem lochtransportierenden Polythiophen und einem elektronentransportierenden Fulleren-Derivat, versetzt mit den entsprechenden Nanopartikel wie beispielsweise Nanokristalle aus Bleisulfid und/oder Bleiselenid. Die Nanopartikel liegen beispielsweise in dieser organisch basierten photoaktiven Schicht gelöst oder beispielsweise auch kolloidal verteilt vor.

Die Anode 8 ist beispielsweise aus Indium-Zinn-Oxid (ITO), Gold, Palladium, Silber oder Platin aufgebaut und wird durch ein Sputter- oder Aufdampfverfahren hergestellt.

Die darauf folgenden aktiven organischen Schichten werden ebenfalls großflächig abgeschieden, zum Beispiel mittels Spin-Coating, Spray Coating, Rakeln (doctor blading), Dip Coating, Siebdruck, Flexodruck, Slit Coating, Ink-Jet Druck etc. Diese Verfahren erlauben eine kostengünstige Beschichtung von großen Flächen, vor allem da keine Strukturierung des Halbleiters innerhalb der aktiven Sensorfläche erforderlich ist.

Die Kathode 9 kann beispielsweise aus Ca, Al, Ag, ITO, LiF, Mg oder verschiedenen Kombinationen dieser Materialien aufgebaut sein und wird typischerweise durch thermisches Verdampfen oder Elektronenstrahlverdampfen aufgebracht.

Durch die unterschiedlichen Austrittsarbeiten der beiden Elektroden wird bereits ein internes elektrisches Feld aufgebaut, das die Elektron-Loch-Paare, die durch Absorption von Lichtquanten entstehen, trennt.

Figur 2 zeigt die Empfindlichkeit der organischen Photodetektoren anhand eines Diagramms, in dem die externen Quanteneffizienzen für die drei Materialsysteme a) PbS:P3HT, b)PbS:PCBM und c)PbS:P3HT:PCBM. Die Messungen zeigen Werte bei 5V Rückwärtsspannung. Ohne die PbS Nanokristalle wäre für Wellenlängen größer als ca. 670nm keine externe Quanteneffizienz messbar, da die Materialien ohne PbS in diesem langwelligen Bereich transparent sind. Somit wäre die externe Quanteneffizient ohne PbS Nanokristalle in dem in Einsatz in Abb. 2 gezeigten Spektralbereich gleich 0. Im sichtbaren Spektralbereich bis 670nm wären ohne die PbS Nanokristalle die Werte kleiner 100%, da kein Photoleitungseffekt auftritt.

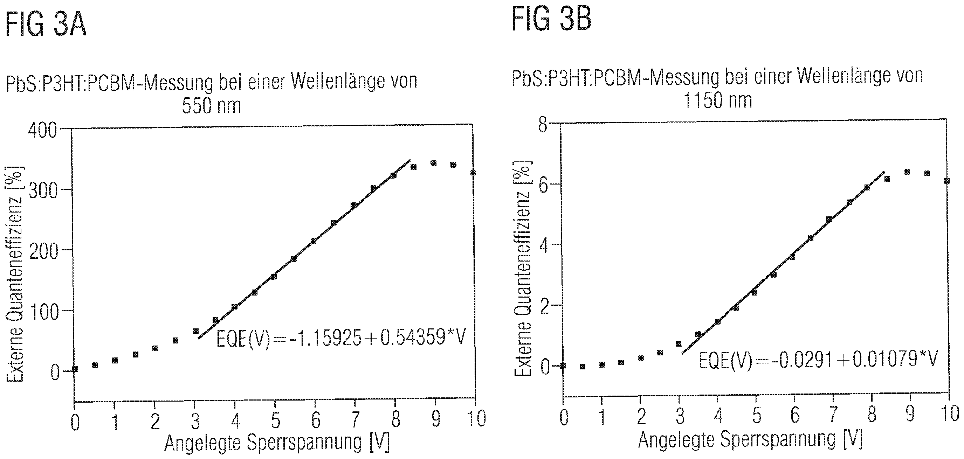

Figuren 3a und 3b zeigen die externe Quanteneffizienz in Abhängigkeit von der angelegten Rückwärtsspannung (Photoleiteffekt). Durch Erhöhung der Spannung kann bis zu einem gewissen Bereich die Extraktion verbessert sowie die Verstärkung durch die Photoleitung ausgenutzt werden. Wie zu sehen ist, ist dieser Effekt linear in einem bestimmten Spannungsbereich.

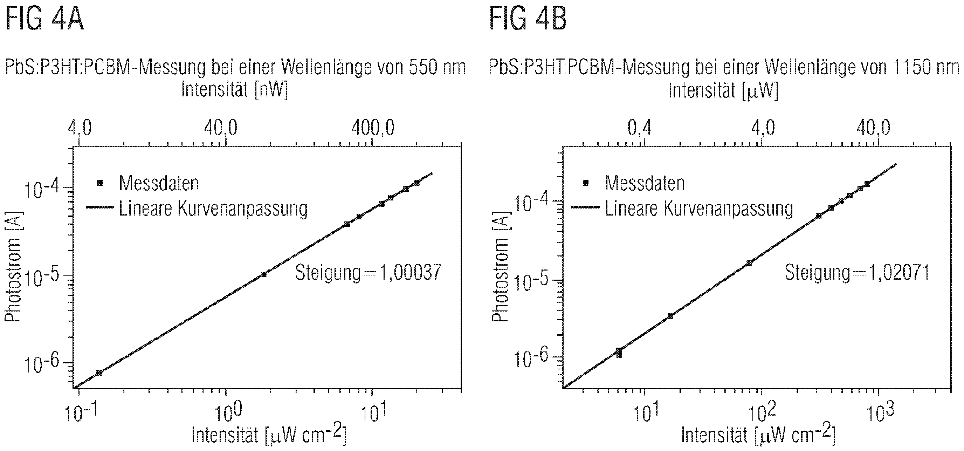

In den Figuren 4a und 4b sind Linearitätsmessungen bei den beiden Wellenlängen von 550nm und 1150nm gezeigt. Wie zu erkennen ist, zeigen die mit PbS Nanokristallen modifizierten Photodetektoren ein lineares Signalverhalten gegenüber der eingestrahlten Lichtintensität über mehr als 2 Größenordnungen.

Mit der vorliegenden Erfindung ist es erstmals möglich, kostengünstig und großflächig Photodetektoren speziell für den Imagerbereich herzustellen. Im Gegensatz zu den bisher bekannten Photodetektoren wie dem Bolometer, II-VI-Halbleiter und Quantentopf-Detektoren verlangen die neuen Photodetektoren, die halbleitende Nanopartikel zur Verschiebung des Detektionsbereichs enthalten, keinen technischen und kostenintensiven Aufwand bei der Herstellung und können auf flexiblen Substraten durch einfache Druckverfahren aufgebaut werden.

## Patentansprüche

1. Photodetektor auf organischer Basis, der eine erste Elektrode, eine zweite Elektrode und zumindest eine zwischen den beiden Elektroden angeordnete organisch basierte photoaktive Schicht umfasst, wobei die photoaktive Schicht halbleitende Nanopartikel enthält,
**dadurch gekennzeichnet, dass** die photoaktive Schicht eine Bulk-Heterojunction mit einem lochtransportierenden Polythiophen und einem elektronentransportierenden Fulleren-Derivat ist, welche mit den Nanopartikeln versetzt ist.

2. Photodetektor nach Anspruch 1, wobei die enthaltenen Nanopartikel zumindest teilweise in Form von Nanokristallen vorliegen.

3. Photodetektor nach einem der Ansprüche 1 oder 2, wobei die halbleitenden Nanopartikel in der organisch basierten photoaktiven Schicht löslich sind.

4. Photodetektor nach einem der Ansprüche 1 bis 3, wobei die Nanopartikel in der photoaktiven Schicht zumindest zum Teil kolloidal enthalten sind.

5. Photodetektor nach einem der vorstehenden Ansprüche, wobei die Nanopartikel aus Bleisulfid, Cadmiumtellurid (CdTe), Quecksilbertellurid (HgTe) und/oder Bleiselenid (PbSe) sind.

6. Verfahren zur Herstellung eines Photodetektors auf organischer Basis nach einem der Ansprüche 1 bis 5, wobei zumindest die photoaktive Schicht mit Nanopartikel aus einer Lösung herstellbar ist.

7. Verwendung eines Photodetektors auf organischer Basis nach einem der Ansprüche 1 bis 5 in der IR-Tomographie (IR-imaging) und in der Sicherheitstechnik.

## Claims

1. Organically-based photodetector, which comprises a first electrode, a second electrode and at least one organically-based photoactive layer arranged between the two electrodes, wherein said photoactive layer contains semiconducting nanoparticles,
**characterised in that** the photoactive layer is a bulk heterojunction with a hole-transporting polythiophene and an electron-transporting fullerene derivative, which is displaced by the nanoparticles.

2. Photodetector according to claim 1, wherein the contained nanoparticles are present at least partially in the form of nanocrystals.

3. Photodetector according to one of claims 1 or 2, wherein the semiconducting nanoparticles are soluble in the organically-based photoactive layer.

4. Photodetector according to one of claims 1 to 3, wherein at least some of the nanoparticles in the photoactive layer are contained at least partially in colloidal state.

5. Photodetector according to one of the preceding claims, wherein the nanoparticles are made from lead sulfide, cadmium telluride (CdTe), mercury telluride (HgTe) and/or lead selenide (PbSe).

6. Method for producing an organically-based photodetector according to one of claims 1 to 5, wherein at least the photoactive layer may be produced with nanoparticles from a solution.

7. Use of an organically-based photodetector according to one of claims 1 to 5 in IR tomography (IR imaging) and in safety engineering.

## Revendications

1. Photodétecteur à base organique, qui comprend une première électrode, une deuxième électrode et au moins une couche photoactive à base organique disposée entre les deux électrodes, la couche photoactive contenant des nanoparticules semi-conductrices,
**caractérisé en ce que** la couche photoactive est une hétérojonction bulk ayant un polythiophène de transport de trous et un dérivé de fullerène de transport d'électrons, laquelle est additionnée des nanoparticules.

2. Photodétecteur suivant la revendication 1, dans lequel les nanoparticules contenues se présentent, au moins en partie, sous la forme de nanocristaux.

3. Photodétecteur suivant l'une des revendications 1 ou 2, dans lequel les nanoparticules semi-conductrices sont solubles dans la couche photoactive à base organique.

4. Photodétecteur suivant l'une des revendications 1 à 3, dans lequel les nanoparticules sont contenues dans la couche photoactive, au moins en partie, colloidalement.

5. Photodétecteur suivant l'une des revendications précédentes, dans lequel les nanoparticules sont en sulfure de plomb, en tellurure de cadmium (CdTe), en tellurure d'argent (HgTe) et/ou en séléniure de plomb (PbSe).

6. Procédé de fabrication d'un photodétecteur à base organique suivant l'une des revendications 1 à 5, dans lequel au moins la couche photoactive, ayant des nanoparticules, peut être préparée à partir d'une solution.

7. Utilisation d'un photodétecteur à base organique suivant l'une des revendications 1 à 5, dans la tomographie IR (imagerie IR) et dans la technique de sécurité.
